# EUROPEAN PATENT APPLICATION

(11) **EP 4 653 889 A1**
(43) Date of publication of application: **26.11.2025**
(21) Application number: 24891585.2
(22) Date of filing: 03.07.2024
(51) Int. Cl.: G01R 31/367, G01R 31/389, G01R 31/396, G01R 31/392, G01R 31/382, H01M 10/48, H01M 10/42

(54) **METHOD FOR DETERMINING TEMPERATURE OF SUBJECT BATTERY AND ELECTRONIC DEVICE FOR PERFORMING SAME**

(30) Priority: 15.11.2023 KR 20230158491
(71) Applicant: LG Energy Solution, Ltd., Seoul 07335 (KR)
(72) Inventor: JO, Yongmin, Daejeon 34122 (KR)
(74) Representative: Hoffmann Eitle
(86) International application number: PCT/KR2024/009397
(87) International publication number: WO 2025/105636

(57) **Abstract**

This method, performed by an electronic device, for determining a temperature of a subject battery includes the steps of: acquiring a first state value of the subject battery at a first time point and a first reference temperature measurement value measured at the first time point by using a temperature sensor in relation to the temperature of the subject battery; acquiring a first impedance value of the subject battery at the first time point by performing electrochemical impedance spectroscopy with respect to the subject battery at the first time point; updating a lookup table area corresponding to state values of the subject battery at a first time point and a second time point subsequent to the first time point, reference temperature measurement values of the subject battery, and impedance values of the subject battery; determining whether the lookup table has been updated to a predefined completeness or more; and when the lookup table has been updated to the predefined completeness or more, determining the temperature of the subject battery on the basis of the lookup table.

## Description

### Technical Field

The present disclosure relates to a method of determining the temperature of a target battery and an electronic device operating the same.

### Background Art

The technology to measure the temperature of a battery is essential to maintaining battery safety and performance and to properly operate the battery in various environments such as driving a vehicle, and various studies are being conducted to accurately measure the temperature according to battery use through temperature sensors or a battery management system (BMS). In particular, the need for strategies to operate batteries in appropriate environments is increasing as batteries age.

### Detailed Description of the Invention

### Technical Goals

The technical tasks that this embodiment seeks to accomplish are not limited to the technical tasks described above, and additional technical tasks can be inferred from the following examples.

### Technical solutions

According to an aspect, there is provided method of determining a temperature of a target battery operated by an electronic device, the method including obtaining a first state value of the target battery at a first time point and a first reference temperature measurement value measured at the first time point using a temperature sensor in relation to the temperature of the target battery, by performing electrochemical impedance spectroscopy (EIS) on the target battery at the first time point, obtaining a first impedance value of the target battery at the first time point, updating lookup table areas corresponding to state values of the target battery, reference temperature measurement values of the target battery and impedance values of the target battery at the first time point and a second time point after the first time point, determining whether a look up table is updated to a predefined level of completion or higher, and when the lookup table is updated to the predefined level of completion or higher, determining the temperature of the target battery based on the lookup table.

The look up table may include axes of predefined dimensions, wherein the axes of predefined dimensions relate to at least one value among a state value (Sox) of the target battery, a reference temperature measurement value, and an impedance value of the target battery, and the state value of the target battery comprises at least one of a charge state value (SoC), a health state value (SoH) and a power state value (SoP) of the target battery.

The the updating look up table areas may include obtaining a second state value of the target battery, a second reference temperature measurement value of the target battery, and a second impedance value of the target battery of the second time point that is after the first time point, and when the first state value and the second state value are identical, the first reference temperature measurement value and the second reference temperature measurement value are identical, and a difference between the first impedance value and the second impedance value is greater than or equal to a threshold value, updating the lookup table areas corresponding to the second state value of the target battery, the second reference temperature measurement value of the target battery, and the second impedance value at the second time point with the second temperature measurement value based on a second impedance value .

The determining may include obtaining a second state value of the target battery, a second reference temperature measurement value of the target battery, and a second impedance value of the target battery of the second time point after the first time point, and when the first state value and the second state value are identical, the first reference temperature measurement value and the second reference temperature measurement value are identical, and a difference between the first impedance value and the second impedance value is greater than or equal to a threshold value, determining a second temperature measurement value based on the second impedance value as the temperature of the target battery at the second time point.

The the updating lookup table areas may include obtaining a second state value of the target battery, a second reference temperature measurement value of the target battery, and a second impedance value of the target battery of the second time point after the first time point, and when the first state value and the second state value are identical, the first reference temperature measurement value and the second reference temperature measurement value are identical, and a difference between the first impedance value and the second impedance value is less than a threshold value, updating the lookup table areas corresponding to the second state value of the target battery, the second reference temperature measurement value of the target battery, and the second impedance value of the second time point with a first temperature measurement value based on the first impedance value.

The determining may include obtaining a second state value of the target battery, a second reference temperature measurement value of the target battery, and a second impedance value of the target battery of the second time point after the first time point, and when the first state value and the second state value are identical, the first reference temperature measurement value and the second reference temperature measurement value are identical, and a difference between the first impedance value and the second impedance value is less than a threshold value, determining a first temperature measurement value based on the first impedance value as the temperature of the target battery at the second time point.

The determining may include obtaining a second state value of the target battery, a second reference temperature measurement value of the target battery, and a second impedance value of the target battery of the second time point after the first time point, and when no temperature measurement value is present corresponding to the lookup table areas corresponding to the second state value of the target battery, the second reference temperature measurement value of the target battery and the second impedance value, determining the temperature of the target battery at the second time point based on an interpolated temperature measurement value.

The method according to the aspect may further include, when completeness of the lookup table is below the predefined level of completion, determining the first reference temperature measurement value as the temperature of the target battery.

The first time point and the second time point may be standby time points where no charging or discharging of the target battery occurs.

According to another aspect, there is provided an electronic device that performs a method of determining a temperature of a target battery, the electronic device including a communication device configured to communicate with a BMS of the target battery, a memory, and a controller that is configured to obtain a first state value of the target battery at a first time point and a first reference temperature measurement value measured at the first time point using a temperature sensor in relation to the temperature of the target battery, by performing electrochemical impedance spectroscopy (EIS) on the target battery at the first time point, obtain a first impedance value of the target battery at the first time point, update lookup table areas corresponding to state values of the target battery, reference temperature measurement values of the target battery and impedance values of the target battery at the first time point and the second time point after the first time point, determine whether a look up table is updated to a predefined level of completion or higher, and when the lookup table is updated to the predefined level of completion or higher, determine the temperature of the target battery based on the lookup table.

The technical tasks to be achieved by the present example embodiments are not limited to the technical tasks described above, and other technical tasks may be inferred from the following example embodiments.

### Effects of the Invention

According to the method for determining the temperature of a target battery according to the present disclosure, unlike cases where the battery temperature is determined only by a temperature sensor or only by interpreting the impedance obtained through impedance analysis, the battery temperature may be measured more accurately as the battery ages, and data management may be facilitated by using the lookup table generated during the measurement process.

Additional aspects of example embodiments will be set forth in part in the description which follows and, in part, will be apparent from the description, or may be learned by practice of the disclosure.

### Brief Description of Drawings

FIG. 1 is a diagram illustrating a system for determining the temperature of a target battery according to an example embodiment.
FIG. 2 is a block diagram illustrating the configuration of an electronic device that determines the temperature of a target battery according to an example embodiment.
FIG. 3 is a drawing for explaining a method of measuring the temperature of a battery using a temperature sensor.
FIG. 4 is a drawing for explaining EIS.
FIGS. 5A and 5B are flowcharts illustrating the operation of an electronic device for determining the temperature of a target battery according to an example embodiment.
FIGS. 6A and 6B are drawings for explaining a lookup table used in a method for determining the temperature of a target battery according to an example embodiment.

### Mode for Carrying Out the Invention

Terms used in the example embodiments are selected from currently widely used general terms when possible while considering the functions in the present disclosure. However, the terms may vary depending on the intention or precedent of a person skilled in the art, the emergence of new technology, and the like. Further, in certain cases, there are also terms arbitrarily selected by the applicant, and in the cases, the meaning will be described in detail in the corresponding descriptions. Therefore, the terms used in the present disclosure should be defined based on the meaning of the terms and the contents of the present disclosure, rather than the simple names of the terms.

Throughout the specification, when a part is described as "comprising or including" a component, it does not exclude another component but may further include another component unless otherwise stated.

Expression "at least one of a, b and c" described throughout the specification may include "a alone," "b alone," "c alone," "a and b," "a and c," "b and c" or "all of a, b and c."

In the present disclosure, a "terminal" may be implemented as, for example, a computer or a portable terminal capable of accessing a server or another terminal through a network. Here, the computer may include, for example, a notebook, a desktop computer, and/or a laptop computer which are equipped with a web browser. The portable terminal may be a wireless communication device ensuring portability and mobility, and include (but is not limited to) any type of handheld wireless communication device, for example, a tablet PC, a smartphone, a communication-based terminal such as international mobile telecommunication (IMT), code division multiple access (CDMA), W-code division multiple access (W-CDMA), long term evolution (LTE), or the like.

Hereinafter, example embodiments of the present disclosure will be described in detail with reference to the accompanying drawings so that those of ordinary skill in the art to which the present disclosure pertains may easily implement them. However, the present disclosure may be implemented in multiple different forms and is not limited to the example embodiments described herein.

Hereinafter, example embodiments will be described in detail with reference to the drawings.

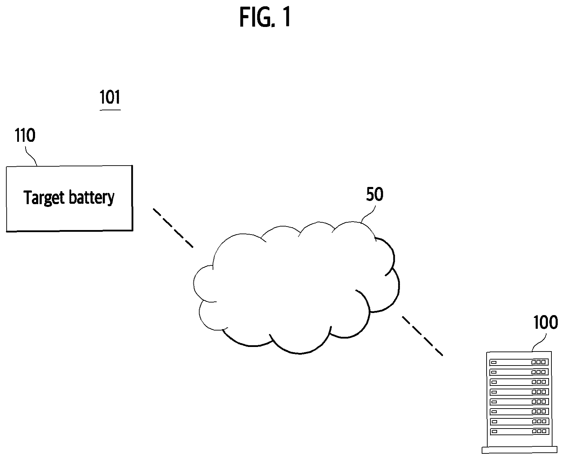

FIG. 1 is a diagram illustrating a system for determining the temperature of a target battery according to an example embodiment.

Referring to FIG. 1, a system 101 for determining the temperature of the target battery according to one example embodiment of the present disclosure may include a target battery 110 which is an object of which temperature to be measured, an electronic device 100 for performing temperature measurement of a target battery 110, and a network 50 that transmits information obtained from the BMS of the target battery 110 to the electronic device 100.

As a device for processing various processes for measuring the temperature of the target battery 110, the electronic device 100 may obtain various information about the electronic device from the BMS of the target battery 110, for example.

Further, the electronic device 100 may generate a lookup table that is used to determine the temperature of the target battery 110. For example, the electronic device 100 may collect and define various data according to the temperature and state value of the target battery 110. In addition, the electronic device 100 may analyze various pieces of information about the obtained target battery 110 and update the values in the lookup table, and perform the overall process of continuous management.

The electronic device 100 may also include a number of computer systems or computer software implemented as network servers, and provide various information by organizing it into web pages. For example, the electronic device 100 may refer to a computer system and computer software that receives a request to perform an operation by connecting to a subordinate device that can communicate with other network servers through a computer network such as internet and the Internet, and providing a result of the operation by performing the operation. In addition, the electronic device 100 may be understood as a broad concept that includes a series of applications that may run on a network server and various databases built inside. For example, the electronic device 100 may be implemented using a network server program that is provided in various ways depending on the operating system, such as DOS, Windows, Linux, UNIX and MacOS.

The network 50 may serve to connect the electronic device 100 and the target battery 110, or the electronic device 100 and an external device (not illustrated). For example, the network 50 may provide a connection path so that the BMS of the target battery 110 may be connected to the electronic device 100 and transmit and receive information.

The operations of the system 101 for determining the temperature of the target battery according to one embodiment of the present disclosure may be implemented via the electronic device 100, and the target battery 110 may be connected to the system 101 to determine the temperature of the target battery via the network 50. The electronic device 100 may store information received from the target battery 110 in a database, or provide information stored in the database to the target battery 110.

The system 101 for determining the temperature of the target battery 110 according to various embodiments may be implemented as a single physical device, and may be implemented in a manner in which multiple physical devices are organically combined. For example, some of the components included in the system 101 that determine the temperature of the target battery 110 may be implemented by any one physical device, and the other components included in the system 101 that determine the temperature of the target battery 110 may be implemented as other physical devices. For example, any one physical device may be implemented as part of the electronic device 100, and the other physical devices may be implemented as part of the target battery 110 or as part of an external device (not illustrated). In some cases, each component included in the system 101 that determines the temperature of the target battery 110 may be distributed and placed in different physical devices and the distributed components may be organically combined in order to perform the function and operation of the system 101 to determine the temperature of the target battery 110.

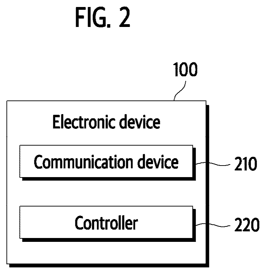

FIG. 2 is a block diagram illustrating the configuration of an electronic device that determines the temperature of a target battery according to an example embodiment.

FIG. 2 illustrates an exemplary, simplified block diagram of the electronic device 100 that may be used to implement at least one example embodiment of the present disclosure. In various example embodiments, the electronic device 100 may be used to implement any system or method described in the present disclosure. For example, the electronic device 100 may be configured to be used as any electronic device including data server, web server, portable computing device, personal computer, tablet computer, workstation, mobile phone, smart phone or any other device described below.

Referring to FIG. 2, the electronic device 100 for performing battery temperature measurement according to one example embodiment may include a communication device 210 that communicates with the BMS of the target battery 110.

For example, the electronic device 100 may include the communication device 210 including one or more transceivers (not illustrated). As a device for performing wired/wireless communication, the communication device 210 may communicate with the BMS or an electronic device of the external target battery. The external electronic device may be a terminal or a server. Further, the communication technologies used by the communication device 210 may include global system for mobile communication (GSM), code division multi access (CDMA), long term evolution (LTE), 5G, wireless LAN (WLAN), wireless-fidelity (Wi-Fi), Bluetooth^{™}, radio frequency identification (RFID), infrared data association (IrDA) , ZigBee, and near field communication (NFC).

The electronic device 100 may include a controller 220 including a memory (not illustrated) and one or more cache memories and a memory controller configured to communicate with the memory. Additionally, the electronic device 100 may include other devices that may be connected to the electronic device 100 via one or more ports (for example, a universal serial bus (USB), a headphone jack, a lightning connector, a thunderbolt connector and so on). A device connectable to the electronic device 100 may include a plurality of ports configured to accept fiber optic connectors. The configuration of the illustrated electronic device 100 is intended only as a specific example for the purpose of illustrating preferred example embodiments of the device. The illustrated electronic device 100 only shows components relevant to the present example embodiments. Therefore, it is apparent to those skilled in the art that other general components may be included in addition to the components illustrated in the electronic device 100. The controller 220 may be used to cause the electronic device 100 to provide any of the operations or functions described in the present disclosure. For example, the controller 220 may control the electronic device 100 in general by executing programs stored in the memory within the electronic device 100. The controller 220 may include a central processing unit (CPU), a graphics processing unit (GPU), an application processor (AP), and so on, provided within the electronic device 100. The memory is a hardware that stores various data processed within the electronic device 100, and the memory is located within the controller 220 in the electronic device 100 and may store data processed and data to be processed through the controller 220. Further, the memory may store not only basic programming and data structures that may provide the functionality of at least one embodiment of the present disclosure but also applications (programs, code modules and commands) and drivers that may provide the functionality of example embodiments of the present disclosure. The memory may include random access memory (RAM) such as dynamic random access memory (DRAM) and static random access memory (SRAM), read-only memory (ROM), electrically erasable programmable read-only memory (EEPROM), CD-ROM, Blu-ray or other optical disk storage, hard disk drive (HDD), solid state drive (SSD), or flash memory, but example embodiments according to the present disclosure are not limited to the specific above described example embodiments.

For example, the controller 220 may be configured to: obtain a first state value of the target battery at the first time point, and a first reference temperature measurement value measured at the first time point using a temperature sensor in relation to the temperature of the target battery; obtain a first impedance value of the target battery at the first time point by performing the EIS on the target battery at the first time point; update the lookup table areas corresponding to a state value of the target battery, a reference temperature measurement value of the target battery, and an impedance value of the target battery at the first time point and the second time point that is after the first time point; determine whether the lookup table is updated to a predefined level of completion or not; and when the lookup table is updated to the predefined level of completion or higher, determine the temperature of the target battery based on the lookup table.

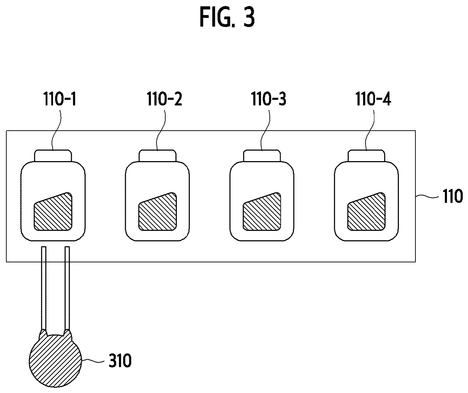

FIG. 3 is a drawing for explaining a method of measuring the temperature of a battery using a temperature sensor.

Referring to FIG. 3, in order to determine the temperature of the target battery 110, the temperatures of multiple battery cells 110-1, 110-2, 110-3 and 110-4 included in the target battery 110 are measured using a negative temperature coefficient thermistor (NTC) element 310 that has the characteristic that the resistance value decreases as the temperature increases. However, there are several difficulties in measuring the temperature of each of the battery cells 110-1, 110-2, 110-3 and 110-4 by applying the NTC element 310 to each of the battery cells 110-1, 110-2, 110-3 and 110-4. For example, when connecting the NTC element 310 individually to each of the battery cells 110-1, 110-2, 110-3 and 110-4, the increased complexity of wiring and connecting components may increase the potential for errors in the temperature measurement process, and connectivity problems may reduce the reliability of the entire system. Further, since an additional NTC element 310 must be installed in each of the battery cells 110-1, 110-2, 110-3 and 110-4, additional space requirements arise within the target battery 110, making it difficult to place additional NTC elements 310 within the limited space of the target battery 110. Further, when there are multiple NTC elements 310, difficulties may arise when replacing each of the battery cells 110-1, 110-2, 110-3 and 110-4, and additional cost issues may arise with purchasing and installing the NTC element 310.

Because of the problems, the temperature of the target battery 110 is estimated with a temperature value obtained by applying the NTC element 310 to one battery cell (for example, the battery cell 110-1) among the battery cells 110-1, 110-2, 110-3 and 110-4, and in this case, since the surface temperature of the battery cell 110-1 is mainly measured, it is difficult to measure the internal core temperature of the target battery 110.

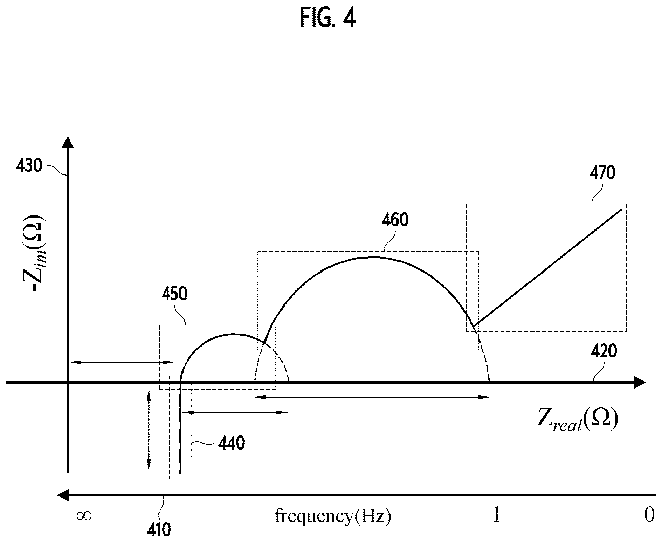

FIG. 4 is a drawing for explaining EIS.

Referring to FIG. 4, the result of battery impedance analysis may be identified using the EIS used in a method for determining the temperature of the target battery according to an example embodiment. The EIS refers to a method of interpreting the Nyquist plot obtained by dividing impedance information, which is obtained by continuously changing the frequency 410 of AC power and applying it to the target battery, into a real component 420 and an imaginary component 430.

Interpreting the electrochemical process of the Nyquist plot in relation to the impedance analysis of the target battery in impedance spectroscopy involves analyzing four major areas on the Nyquist plot. For example, an area 440 that is the intercept of the axis representing the real component 420 of the impedance information may be used to analyze impedance information related to the characteristics of electrolyte ion conductivity of the electrolyte resistance of the target battery and the characteristics of the external electrolyte resistance. For example, a first semicircle area 450 of the impedance information obtained by changing a value of the frequency 410 may be used to analyze charge transfer impedance information in the SEI generated on the surface of the inner electrode particles in relation to the solid electrolyte interphase (SEI). For example, a second semicircle area 460 of impedance information obtained by changing a value of the frequency 410 may be used to analyze charge transfer impedance information that represents the lithium ion oxidation-reduction reaction at the electrode material interface due to charge transfer resistance, a phenomenon that occurs when charges are transferred at the electrode interface of the target battery. For example, a linear area 470 obtained by changing a value of the frequency 410 may include Warburg impedance information obtained in a low frequency area, and may be used to analyze the diffusion phenomenon of lithium ions (Li ions) related to the chemical diffusion resistance of lithium ions due to intercalation into the particle crystal structure within the target battery.

It is known through various studies that among values appearing in the impedance spectroscopy, the area 440, which is the intercept of the axis representing the real component 420 of the impedance information, includes the point where the value of the imaginary component 430 of the impedance information becomes 0, and the temperature of the target battery may be measured through the frequency at which the value of the corresponding imaginary component 430 becomes 0. However, the impedance value obtained through the impedance spectroscopy changes sensitively depending on the state value (for example, SoC) of the target battery, the degree of degradation of the target battery, and the internal circuit connections of the target battery, and thus it is difficult to accurately estimate the temperature of the target battery using only the impedance value of the target battery obtained through the impedance spectroscopy.

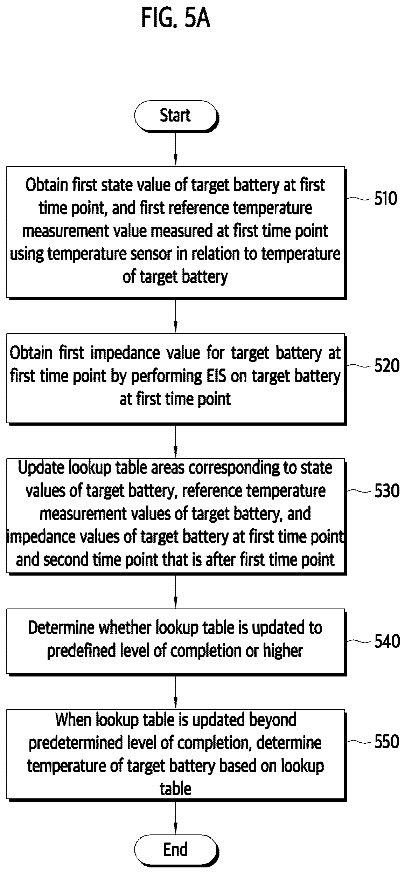

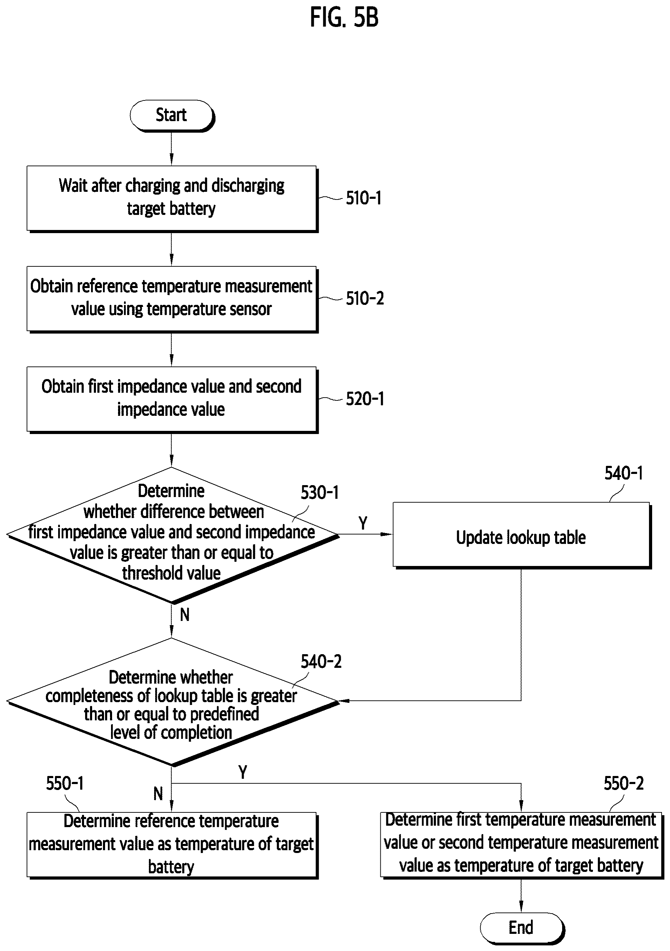

FIGS. 5A and 5B are flowcharts illustrating the operation of an electronic device for determining the temperature of a target battery according to an example embodiment.

Referring to FIG. 5A, in operation 510, the electronic device 100 according to an example embodiment of the present disclosure may obtain a first state value of the target battery at the first time point, and a first reference temperature measurement value measured at the first time point using a temperature sensor in relation to the temperature of the target battery. Here, the first time point may refer to a specific time point at which updated is the lookup table that the electronic device 100 uses to determine the temperature of the target battery. Here, the first reference temperature measurement value may indicate a temperature measurement value measured using a temperature sensor including an NTC element as described with reference to FIG. 3, for example.

In operation 520, the electronic device 100 according to one example embodiment may obtain the first impedance value for the target battery at the first time point by performing the EIS on the target battery at the first time point. At this time, the electronic device 100 may perform an operation of obtaining the first impedance value through the EIS as described with reference to FIG. 4, for example.

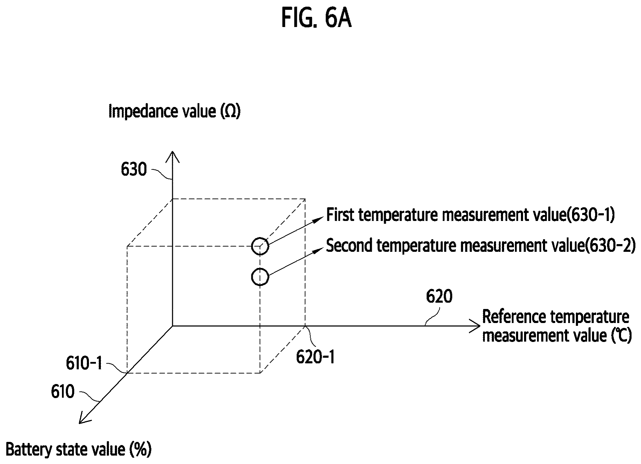

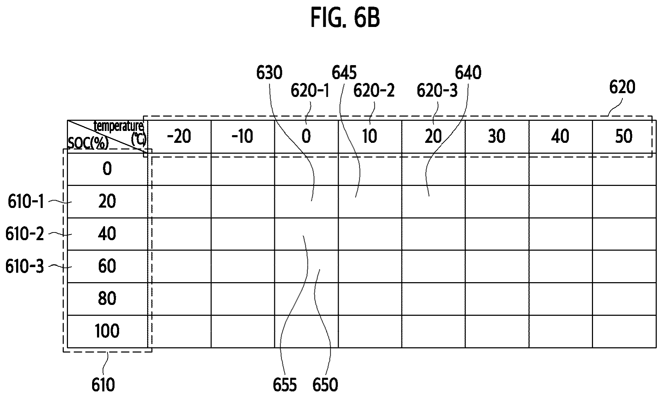

In operation 530, the electronic device 100 according to one example embodiment may update the lookup table areas corresponding to state values of the target battery, reference temperature measurement values of the target battery, and impedance values of the target battery at the first time point and the second time point that is after the first time point. Here, the second time point may indicate any time point after the first time point at which updated is the look up table that the electronic device 100 uses to determine the temperature of the target battery. Here, the state values of the target battery may include the state value of the target battery at the first time point and the state value of the target battery at the second time point, and here, the state value may include at least one of the charge state value (SoC), the health state value (SoH) and the power state value (SoP) of the target battery. Here, the reference temperature measurement values of the target battery may include a reference temperature measurement value of the target battery at the first time point and a reference temperature measurement value of the target battery at the second time point. Here, the impedance values of the target battery may include a first impedance value of the target battery at the first time point and a second impedance value of the target battery at the second time point. Here, the lookup table may refer to a table of various dimensions that is used to retrieve and connect data in a database or software system, and the lookup table may include axes of predefined dimensions related to at least one of a state value (Sox) of the target battery, a reference temperature measurement value, and an impedance value of the target battery, as described with reference to FIGS. 6A and 6B below. Here, updating the lookup table may indicate the entire process of getting the temperature measurement value corresponding to the state value of the target battery, the reference temperature measurement value, and the impedance value of the target battery at a specific time point, and may indicate modifying the existing temperature measurement value to the subsequent temperature measurement value by reflecting the change in the temperature measurement value according to the state value of the target battery, the reference temperature measurement value, and the impedance value of the target battery between different time points (for example, the first time point and the second time point).

In operation 540, the electronic device 100 according to one example embodiment may determine whether the lookup table is updated to a predefined level of completion or higher. Here, the predefined level of completion may be defined as the ratio of the number of cells for which temperature measurement values based on the impedance are obtained and the total number of cells in the lookup table determined based on various scenarios for measuring the temperature of the target battery . For example, when the total number of cells in the lookup table is 100 and the predefined level of completion is that the number of cells from which temperature values based on the impedance are obtained is 80 or more among 100 cells, the predetermined level of completion may be 80%.

In operation 550, when the lookup table is updated beyond the predetermined level of completion, the electronic device 100 according to one example embodiment may determine a temperature of the target battery 110 based on the lookup table.

Referring to FIG. 5B, in operation 510-1, the electronic device 100 according to one example embodiment may be waiting until a sufficient amount of time is passed after charging and discharging the target battery. Through this, the electronic device may perform more precise measurements on the target battery after sufficient time is passed after charging and discharging, when there is no change in the state value of the target battery and the reference temperature measurement value of the target battery, which is at the time when the cell temperature becomes equal to the outside temperature (for example, about four hours later). For example, both the first time point and the second time point described above may correspond to standby time points during which no charging or discharging of the target battery occurs, and the electronic device 100 may obtain data of the corresponding standby time point.

In operation 510-2, the electronic device 100 may obtain a reference temperature measurement value using a temperature sensor. The electronic device 100 may obtain a reference temperature measurement value for a battery cell using a temperature sensor, such as the NTC element described in FIG. 3, for example.

In operation 520-1, the electronic device 100 may obtain the first impedance value for the target battery at the first time point, and obtain the second impedance value for the target battery at the second time point after the first time point. Further, the electronic device 100 may obtain not only impedance values for the target battery, but also state values of the target battery and reference temperature measurement values of the target battery at each time point.

In operation 530-1, the electronic device 100 may determine whether the difference between the first impedance value and the second impedance value is greater than or equal to the threshold value. Here, the threshold value of the difference between the first impedance value and the second impedance value is a value related to the range that represents the error or inaccuracy that may occur during the measurement or data collection process of impedance values, and may indicate a value for securing the accuracy and reliability of data in the process of obtaining temperature measurement values based on different impedances and determining the temperature of the target battery. For example, when the difference between the first impedance value and the second impedance value is less than the threshold value, the electronic device 100 may determine the temperature of the target battery by determining that the first impedance and second impedance have the same value.

In operation 530-1, when the difference between the first impedance value and the second impedance value is greater than or equal to the threshold value, in operation 540-1, the electronic device 100 may update the lookup table based on the second impedance value. After then, in operation 540-1, determined may be whether the completeness of the lookup table is greater than or equal to the predefined level of completion. In operation 530-1, when the difference between the first impedance measurement value and the second impedance measurement value is less than the threshold value, in operation 540-2, the electronic device 100 determines whether the completeness of the lookup table is greater than or equal to a predefined level of completion, and when the completeness of the lookup table is greater than or equal to the predefined level of completion, in operation 550-2, the electronic device 100 may determine a first temperature measurement value based on a first impedance value or a second temperature measurement value based on a second impedance value as the temperature of the target battery. For example, when the completeness of the lookup table is less than the predefined level of completion, in operation 550-1, the electronic device 100 may determine the reference temperature measurement value as the temperature of the target battery.

FIGS. 6A and 6B are drawings for explaining a lookup table used in a method for determining the temperature of a target battery according to an example embodiment.

Referring to FIG. 6A, the electronic device 100 according to one example embodiment may determine the temperature of the target battery using a lookup table including axis 610 related to the state value (Sox) of the target battery, axis 620 related to the reference temperature measurement value of the target battery, and axis 630 related to the impedance value of the target battery. For example, the electronic device 100 may obtain a state value 610-1 of the target battery, a reference temperature measurement value 620-1 of the target battery, and a first impedance value 630-1 of the target battery, at the first time point, and after then, update the lookup table to a predetermined level of completion or higher based on an impedance value 630-2 of the target battery at the second time point.

In other words, the electronic device 100 may obtain a temperature measurement value according to the corresponding reference temperature measurement value and the corresponding impedance value measured by the battery state value according to the reference temperature measurement value of the target battery, the state value of the target battery, and the impedance value of the target battery at a specific time point, and may determine the temperature measurement value according to the impedance value as the temperature of the battery based on the reference temperature value measured by the temperature sensor according to the completeness of the lookup table.

For example, when the difference between the first impedance value 630-1 and the second impedance value 630-2 is less than the threshold value, the electronic device 100 may update the lookup table based on the first temperature measurement value based on the state value 610-1 of the target battery, the reference temperature measurement value 620-1 and the first impedance value 630-1. In other words, the electronic device 100 may update the lookup table based on the first temperature measurement value based on the first impedance value 630-1 since the difference between the first temperature measurement value based on the first impedance value 630-1 and the second temperature measurement value based on the second impedance value 630-2 will not be large when the first state value, which is the state value of the target battery obtained at the first time point, and the second state value, which is the state value of the target battery obtained at the second time point, are identical, the first reference temperature measurement value and the second temperature measurement value are identical, and the difference between the first impedance value 630-1 and the second impedance value 630-2 is less than the threshold value. Further, when the lookup table is updated to a predefined level of completion or higher, the electronic device 100 may determine the first temperature measurement value based on the first impedance value 630-1 as the temperature of the target battery.

For example, when the difference between the first impedance value 630-1 and the second impedance value 630-2 is greater than or equal to the threshold value, the electronic device 100 may update the lookup table based on the second temperature measurement value based on the state value 610-1, the reference temperature measurement value 620-1 and the second impedance value 630-2 of the target battery. In other words, the electronic device 100 may update the lookup table based on the second temperature measurement value based on the second impedance value 630-2 obtained at the second time point instead of the first temperature measurement value based on the first impedance value 630-1 obtained at the first time point since there will be a large difference between the first temperature measurement value based on the first impedance value 630-1 and the second temperature measurement value based on the second impedance value 630-2 when the first state value, which is the state value of the target battery obtained at the first time point, and the second state value, which is the state value of the target battery obtained at the second time point, are identical, the first reference temperature measurement value and the second temperature measurement value are identical, and the difference between the first impedance value 630-1 and the second impedance value 630-2 is greater than or equal to the threshold value.

When the lookup table is completed to a predefined level of completion or higher, the electronic device 100 may determine the temperature measurement value based on the target battery's impedance value as the temperature of the target battery. For example, when the difference between the first impedance value for the target battery obtained at the first time point and the second impedance value for the target battery obtained at the second time point is less than the threshold value, there will be no significant change in the difference between the first temperature measurement value based on the first impedance value and the second temperature measurement value based on the second impedance value, and thus the electronic device 100 may maintain the first temperature measurement value based on the first impedance value in the lookup table. For example, when the difference between the first impedance value 630-1 for the target battery obtained at the first time point and the second impedance value 630-2 for the target battery obtained at the second time point is greater than or equal to the threshold value, there will be a difference between the first temperature measurement value based on the first impedance value 630-1 and the second temperature measurement value based on the second impedance value 630-2, and thus the electronic device 100 may update the lookup table with the second temperature measurement value based on the second impedance value 630-2.

Referring to FIG. 6B, the example embodiment is identified based on the axis 610 related to the state value of the target battery in the lookup table used in a method for performing battery temperature measurement according to one example embodiment and the axis 620 related to the reference temperature measurement value of the target battery. The lookup table with reference to FIG. 6B is described with that the unit of the axis 610 related to the reference temperature measurement value is 10, and the unit of the axis 620 related to the state value of the target battery is 20%, but the example embodiments of the present disclosure are not limited to the specific cases such as the lookup table illustrated in the drawing.

When the lookup table is updated to the predefined level of completion or higher, and when there is no impedance measurement value corresponding to the state value 610-1 of the target battery and reference temperature measurement value 620-2 in the lookup table and no temperature measurement value according to the impedance measurement value, the electronic device 100 according to the example embodiment may determine the temperature of the target battery based on the interpolated temperature measurement value. For example, when the lookup table is at the predefined level of completion or higher, at the second time point where the temperature of the target battery is to be measured and the state value 610-1 of the target battery corresponds to the value and the corresponding reference temperature measurement value corresponds to 620-1, but when there is no temperature measurement value in a cell 645 corresponding thereto, the electronic device 100 may determine interpolated temperature measurement value obtained by interpolating the temperature measurement values of the cell 630 and a cell 650 as the temperature of the target battery. Here, interpolating the temperature measurement values may indicate interpolating temperature measurement values by using commonly used interpolation methods such as linear interpolation, polynomial interpolation, spline interpolation and quadratic interpolation, in order to maintain continuity of the state value of a specific target battery and temperature measurement values corresponding to adjacent cells of a cell corresponding to a specific reference temperature measurement value.

Similarly, when the lookup table is at a predefined level of completion or higher, at the second time point where the temperature of the target battery is to be measured, the state value of the target battery corresponds to the value 610-2 and the reference temperature measurement value corresponds to 620-1, but when there is no temperature measurement value in a cell 655 corresponding thereto, the electronic device 100 may determine the interpolated temperature measurement value obtained by interpolating the temperature measurement values of the cell 630 and the cell 650 as the temperature of the target battery. Described with reference to FIG. 6B is the process of interpolating temperature measurement values as described above based on the axis 610 related to the state value of the target battery and the axis 620 related to the reference temperature measurement value of the target battery, but it may also be applied based on other axes as described in FIG. 6A, and example embodiments of the present disclosure are not limited to the specific cases.

The example embodiments may be represented by functional block elements and various processing steps. The functional blocks may be implemented in any number of hardware and/or software configurations that perform specific functions. For example, an example embodiment may adopt integrated circuit configurations, such as memory, processing, logic and/or look up table, that may execute various functions by the control of one or more microprocessors or other control device. Similar to that elements may be implemented as software programming or software elements, the example embodiments may be implemented in a programming or scripting language such as C, C++, Java, assembler, etc., including various algorithms implemented as a combination of data structures, processes, routines, or other programming constructs. Functional aspects may be implemented in an algorithm running on one or more processors. Further, the example embodiments may adopt the existing art for electronic environment setting, signal processing, and/or data processing. Terms such as "mechanism," "element," "means" and "configuration" may be used broadly and are not limited to mechanical and physical elements. The terms may include the meaning of a series of routines of software in association with a processor or the like.

The above described example embodiments are mere examples, and other embodiments may be implemented within the scope of the claims to be described later.

## Claims

1. A method of determining a temperature of a target battery operated by an electronic device, the method comprising:
obtaining a first state value of the target battery at a first time point and a first reference temperature measurement value measured at the first time point using a temperature sensor in relation to the temperature of the target battery;
by performing electrochemical impedance spectroscopy (EIS) on the target battery at the first time point, obtaining a first impedance value of the target battery at the first time point;
updating lookup table areas corresponding to state values of the target battery, reference temperature measurement values of the target battery and impedance values of the target battery at the first time point and a second time point after the first time point;
determining whether a look up table is updated to a predefined level of completion or higher; and
when the lookup table is updated to the predefined level of completion or higher, determining the temperature of the target battery based on the lookup table.

2. The method of determining the temperature of the target battery of claim 1, wherein the look up table comprises axes of predefined dimensions,
wherein the axes of predefined dimensions relate to at least one value among a state value (Sox) of the target battery, a reference temperature measurement value, and an impedance value of the target battery, and
wherein the state value of the target battery comprises at least one of a charge state value (SoC), a health state value (SoH) and a power state value (SoP) of the target battery.

3. The method of determining the temperature of the target battery of claim 1, wherein the updating the look up table areas comprises:
obtaining a second state value of the target battery, a second reference temperature measurement value of the target battery, and a second impedance value of the target battery of the second time point that is after the first time point; and
when the first state value and the second state value are identical, the first reference temperature measurement value and the second reference temperature measurement value are identical, and a difference between the first impedance value and the second impedance value is greater than or equal to a threshold value,
updating the lookup table areas corresponding to the second state value of the target battery, the second reference temperature measurement value of the target battery, and the second impedance value at the second time point with the second temperature measurement value based on a second impedance value.

4. The method of determining the temperature of the target battery of claim 1, wherein the determining comprises:
obtaining a second state value of the target battery, a second reference temperature measurement value of the target battery, and a second impedance value of the target battery of the second time point after the first time point; and
when the first state value and the second state value are identical, the first reference temperature measurement value and the second reference temperature measurement value are identical, and a difference between the first impedance value and the second impedance value is greater than or equal to a threshold value,
determining a second temperature measurement value based on the second impedance value as the temperature of the target battery at the second time point.

5. The method of determining the temperature of the target battery of claim 1, wherein the updating the lookup table areas comprises:
obtaining a second state value of the target battery, a second reference temperature measurement value of the target battery, and a second impedance value of the target battery of the second time point after the first time point; and
when the first state value and the second state value are identical, the first reference temperature measurement value and the second reference temperature measurement value are identical, and a difference between the first impedance value and the second impedance value is less than a threshold value,
updating the lookup table areas corresponding to the second state value of the target battery, the second reference temperature measurement value of the target battery, and the second impedance value of the second time point with a first temperature measurement value based on the first impedance value.

6. The method of determining the temperature of the target battery of claim 1, wherein the determining comprises:
obtaining a second state value of the target battery, a second reference temperature measurement value of the target battery, a second impedance value of the target battery of the second time point after the first time point; and
when the first state value and the second state value are identical, the first reference temperature measurement value and the second reference temperature measurement value are identical, and a difference between the first impedance value and the second impedance value is less than a threshold value,
determining a first temperature measurement value based on the first impedance value as the temperature of the target battery at the second time point.

7. The method of determining the temperature of the target battery of claim 1, wherein the determining comprises:
obtaining a second state value of the target battery, a second reference temperature measurement value of the target battery, and a second impedance value of the target battery of the second time point after the first time point; and
when no temperature measurement value is present corresponding to the lookup table areas corresponding to the second state value of the target battery, the second reference temperature measurement value of the target battery and the second impedance value,
determining the temperature of the target battery at the second time point based on an interpolated temperature measurement value.

8. The method of determining the temperature of the target battery of claim 1, further comprising,
when completeness of the lookup table is below the predefined level of completion,
determining the first reference temperature measurement value as the temperature of the target battery.

9. The method of determining the temperature of the target battery of claim 1, wherein the first time point and the second time point are standby time points where no charging or discharging of the target battery occurs.

10. An electronic device that performs a method of determining a temperature of a target battery, the electronic device comprising:
a communication device configured to communicate with a battery management system (BMS) of the target battery;
a memory; and
a controller that is configured to:
obtain a first state value of the target battery at a first time point and a first reference temperature measurement value measured at the first time point using a temperature sensor in relation to the temperature of the target battery;
by performing electrochemical impedance spectroscopy (EIS) on the target battery at the first time point, obtain a first impedance value of the target battery at the first time point;
update lookup table areas corresponding to state values of the target battery, reference temperature measurement values of the target battery and impedance values of the target battery at the first time point and a second time point after the first time point;
determine whether a look up table is updated to a predefined level of completion or higher; and
when the lookup table is updated to the predefined level of completion or higher, determine the temperature of the target battery based on the lookup table.
